# EUROPÄISCHE PATENTANMELDUNG

(11) **EP 2 009 753 A1**
(43) Veröffentlichungstag der Anmeldung: **31.12.2008**
(21) Anmeldenummer: 08009484.0
(22) Anmeldetag: 23.05.2008
(51) Int. Cl.: H01S 5/40, H01S 5/32

(54) **Laserdiodenstapel mit Tunnelübergängen und verringerter Gitterfehlanpassung zum GaAs-Substrat**

(30) Priorität: 29.06.2007 DE 102007030062
(71) Anmelder: OSRAM Opto Semiconductors GmbH, 93055 Regensburg (DE)
(72) Erfinder: Müller, Martin, Dr., 93128 Regenstauf (DE); Grönninger, Günther, 92358 Seubersdorf (DE); Behres, Alexander, Dr., 93309 Kelheim (DE)
(74) Vertreter: Epping - Hermann - Fischer

(57) **Zusammenfassung**

Die vorliegende Erfindung betrifft einen monolithisch integrierten Laserdiodenchip mit einem Aufbau als Mehrfachstrahl-Laserdiode, der auf einem Halbleitersubstrat (3) aus GaAs mindestens zwei übereinander angeordnete Laserstapel (4a,4b,4c) aufweist, die jeweils eine aktive Zone (7) enthalten und über Tunnelübergänge (5) elektrisch in Rühe geschaltet sind. Die aktive Zone (7) ist jeweils zwischen Wellenleiterschichten (8) angeordnet. Die Wellenleiterschichten (8) grenzen an einer von der aktiven Zone abgewandten Seite jeweils an eine Mantelschicht (6) an. Mindestens eine der Wellenleiterschichten (8) oder Mantelschichten (6) mindestens eines Laserstapels (4a,4b,4c) weist AlₓGa₁₋ₓAs, mit 0 ≤ x ≤ 1, und mindestens ein zusätzliches Material der III. oder V. Hauptgruppe auf, so dass sich die Gitterfehlanpassung zwischen der mindestens einen Wellenleiterschicht (8) oder Mantelschicht (6) mit dem mindestens einen zusätzlichen Element und dem Halbleitersubstrat (3) aus GaAs verringert. Dadurch erhöht sich die Lebensdauer des Laserdiodenchips.

## Beschreibung

Diese Patentanmeldung beansprucht die Priorität der deutschen Patentanmeldung 10 2007 030 062.1, deren Offenbarungsgehalt hiermit durch Rückbezug aufgenommen wird.

Die Erfindung betrifft einen monolithisch integrierten Laserdiodenchip mit einem Aufbau als Mehrfachstrahl-Laserdiode gemäß dem Patentanspruch 1.

Derartige Laserdiodenchips mit einem Aufbau als Mehrfachstrahl-Laserdiode sind beispielsweise aus den Druckschriften US 5,212,706 und EP 1051783 B1 bekannt. Die Laserdioden werden üblicherweise als Schichtfolgen aufgewachsen, wobei die einzelnen Schichten unterschiedliche Materialien und folglich unterschiedliche Gitterkonstanten aufweisen können. Unterschiedliche Gitterkonstanten des Substrats und der aufgewachsenen Schichten führen zu Verspannungen, so dass in dem Schichtstapel elastische Energie gespeichert wird und Kräfte zwischen benachbarten Schichten wirken, wodurch die Funktionsweise des Laserdiodenchips beeinträchtigt werden kann. Ist die zwischen zwei Schichten wirkende Kraft zu groß, so entstehen Gitterversetzungen in oder zwischen den Schichten, wodurch die Funktion des Diodenlasers weiter beeinträchtigt werden kann.

Aus der Druckschrift DE 10057698 A1 ist bekannt, dieses Problem durch eine zusätzliche Kontaktschicht, die zwischen dem ersten Diodenlaser und dem zweiten Diodenlaser angeordnet ist, zu beheben, wobei die Kontaktschicht so ausgebildet ist, dass eine Gitterfehlanpassung zwischen dem Substrat und dem ersten Diodenlaser durch eine Gitterfehlanpassung mit entgegengesetzten Vorzeichen zwischen dem Substrat und der Kontaktschicht kompensiert ist.

Durch die so kompensierte Verspannung bleiben allerdings lokale Verspannungen und Gitterfehlanpassungen zwischen benachbarten Schichten bestehen oder werden sogar erhöht.

Der Erfindung liegt die Aufgabe zugrunde, einen monolithisch integrierten Laserdiodenchip mit einem Aufbau als Mehrfachstrahl-Laserdiode anzugeben, bei dem lokale Verspannungen und Gitterfehlanpassungen zwischen dem Halbleitersubstrat aus GaAs und mindestens einer der Wellenleiterschichten oder Mantelschichten verringert sind, so dass sich die Degradation des Laserdiodenchips verlangsamt und sich somit die Lebensdauer des Laserdiodenchips erhöht.

Diese Aufgabe wird durch einen Laserdiodenchip mit den Merkmalen des Patentanspruchs 1 gelöst. Vorteilhafte Ausgestaltungen und Weiterbildungen der Erfindung sind Gegenstand der abhängigen Ansprüche.

Dementsprechend sieht die vorliegende Erfindung einen monolithisch integrierten Laserdiodenchip mit einem Aufbau als Mehrfachstrahl-Laserdiode vor, der auf einem Halbleitersubstrat aus GaAs mindestens zwei übereinander angeordnete Laserstapel aufweist, die jeweils eine aktiven Zone enthalten, die zwischen Wellenleiterschichten angeordnet ist. Die Wellenleiterschichten grenzen an einer von der aktiven Zone abgewandten Seite jeweils an eine Mantelschicht an. Mindestens eine der Wellenleiterschichten oder Mantelschichten mindestens eines Laserstapels weist AlₓGa₁₋ₓAs, mit 0 < x ≤ 1, und mindestens ein zusätzliches Element der III. oder V. Hauptgruppe auf, so dass sich die Gitterfehlanpassung zwischen der mindestens einen Wellenleiterschicht oder Mantelschicht mit dem mindestens einen zusätzlichen Element und dem Halbleitersubstrat aus GaAs verringert.

Durch die Verringerung der Gitterfehlanpassungen zwischen der mindestens einen Wellenleiterschicht oder Mantelschicht und dem Halbleitersubstrat verringern sich lokale Verspannungen zwischen der mindestens einen Wellenleiterschicht oder Mantelschicht und dem Halbleitersubstrat, wodurch sich Kräfte zwischen diesen Schichten verringern. Dadurch verlangsamt sich die Degradation des Laserdiodenchips, wodurch sich die Lebensdauer des Laserdiodenchips vorteilhaft verlängert.

Durch das in der mindestens einen Wellenleiterschicht oder Mantelschicht enthaltene mindestens eine zusätzliche Element der III. oder V. Hauptgruppe zu AlₓGa₁₋ₓAs, mit 0 ≤ x ≤ 1, kann die Alterungsstabilität signifikant erhöht werden. Geeignete zusätzliche Elemente der III. oder V. Hauptgruppe zeichnen sich dadurch aus, dass die Gitterkonstante der Wellenleiterschicht oder Mantelschicht durch das zusätzliche Element derart verändert wird, dass sie sich der Gitterkonstante des Substrats, das GaAs enthält, annähert.

Ein mehrstufiger monolithisch integrierter Laser gemäß der Erfindung kann in einem stabilen quasi-kontinuierlichen (q-cw) Betriebsmodus, der eine hohe thermische Belastung zur Folge hat, verwendet werden, wobei die Vorteile eines mehrstufigen monolithisch integrierten Lasers genutzt werden können. Die Vorteile eines mehrstufigen monolithisch integrierten Laserdiodenchips sind unter anderem eine geringe Stromdichte, eine geringe optische Facettenbelastung und geringere Kosten durch einen reduzierten Montageaufwand.

Des Weiteren kann durch die Verringerung lokaler Gitterfehlanpassungen zwischen mindestens einer Wellenleiterschicht oder Mantelschicht und dem Halbleitersubstrat, insbesondere durch die Verringerung der Gitterfehlanpassung zwischen dem Halbleitersubstrat aus GaAs und der angrenzenden Mantelschicht, die Durchbiegung des Halbleitersubstrats reduziert werden, da sich lokale Verspannungen zwischen diesen Schichten reduzieren und sich somit Kräfte zwischen diesen Schichten verringern. Dadurch reduziert sich die Bruchgefahr des Halbleitersubstrats. Ferner verbessert sich durch die Reduzierung lokaler Verspannungen zwischen dem Halbleitersubstrat aus GaAs und mindestens einer Wellenleiterschicht oder Mantelschicht die Bruchqualität der Facetten beim Brechen in Laserbarren. Zusätzlich erhöht sich die Zuverlässigkeit des Laserdiodenchips.

Vorzugsweise ist das zusätzliche Element, das der mindestens einen Wellenleiterschicht oder Mantelschicht zu AlₓGa₁₋ₓAs, mit 0 ≤ x ≤ 1, zugefügt ist, und das die Gitterkonstante von AlₓGa₁₋ₓAs verringert und somit eine ohne das zusätzliche Element vorhandene kompressive Verspannung verringern kann, P oder N. Ein zusätzliches Element, das der mindestens einen Wellenleiterschicht oder Mantelschicht zu AlₓGa₁₋ₓAs, mit 0 ≤ x ≤ 1, zugefügt werden kann, und das die Gitterkonstante von AlₓGa₁₋ₓAs vergrößert und somit eine ohne das zusätzliche Element vorhandene tensile Verspannung verringern kann, ist bevorzugt In oder Sb.

Bevorzugt verringert sich durch das mindestens eine zusätzliche Element in der mindestens einen Wellenleiterschicht oder Mantelschicht die Gitterkonstante dieser Wellenleiterschicht oder Mantelschicht. Diese Verringerung der Gitterkonstante dieser mindestens einen Wellenleiterschicht oder Mantelschicht hat den Vorteil, dass sich die Gitterkonstante dieser mindestens einen Wellenleiterschicht oder Mantelschicht der Gitterkonstante des Halbleitersubstrats, also der Gitterkonstante von GaAs, annähert, falls die Gitterkonstante der mindestens einen Wellenleiterschicht oder Mantelschicht ohne das mindestens eine zusätzliche Element größer wäre als die Gitterkonstante von GaAs.

Weiterhin ist vorzugsweise vorgesehen, dass sich durch mindestens ein zusätzliches Element in der mindestens einen Wellenleiterschicht oder Mantelschicht die Gitterkonstante dieser Wellenleiterschicht oder Mantelschicht zur Annäherung an die Gitterkonstante des Halbleitersubstrats, also an die Gitterkonstante von GaAs, vergrößert, falls die Gitterkonstante der mindestens einen Wellenleiterschicht oder Mantelschicht ohne das mindestens eine zusätzliche Element kleiner wäre als die Gitterkonstante von GaAs.

Vorzugsweise weisen mindestens eine Wellenleiterschicht und mindestens eine Mantelschicht oder mindestens zwei Wellenleiterschichten oder mindestens zwei Mantelschichten AlₓGa₁₋ₓAs, mit 0 ≤ x ≤ 1, und das mindestens eine zusätzliche Element auf. Dabei weisen bevorzugt die mindestens eine Wellenleiterschicht und die mindestens eine Mantelschicht oder die mindestens zwei Wellenleiterschichten oder die mindestens zwei Mantelschichten das mindestens eine zusätzliche Element in unterschiedlicher Konzentration auf.

Beispielsweise weisen die zwei Mantelschichten des ersten Laserstapels beide als zusätzliches Element zu AlₓGa₁₋ₓAs, mit 0 ≤ x ≤ 1, Phosphor auf. Dabei weist beispielsweise die Mantelschicht, die dem Halbleitersubstrat, das GaAs enthält, zugewandt ist, eine höhere Konzentration an Phosphor auf, als die Mantelschicht, die dem zweiten Laserstapel zugewandt ist.

Dabei ist die Anordnung der Schichten, die AlₓGa₁₋ₓAs, mit 0 ≤ x ≤ 1, und das zusätzliche Element enthalten, nicht auf einen der Laserstapel eingeschränkt. Alternativ kann auch mindestens eine der Schichten des ersten Laserstapels und mindestens eine der Schichten des zweiten Laserstapels das zusätzliche Element in der gleichen oder in einer anderen Konzentration aufweisen.

Eine bevorzugte Ausgestaltung der Erfindung sieht vor, dass in jeder Wellenleiterschicht und jeder Mantelschicht mindestens eines Laserstapels AlₓGa₁,-ₓAs, mit 0 ≤ x ≤ 1, und mindestens ein zusätzliches Element enthalten ist. Auf diese Weise kann eine besonders gute Gitteranpassung aller Schichten mindestens eines Laserstapels an die Gitterkonstante von GaAs erzielt werden.

Besonders bevorzugt ist in jeder Wellenleiterschicht und in jeder Mantelschicht jedes Laserstapels AlₓGa₁₋ₓAs, mit 0 ≤ x ≤ 1, und das mindestens eine zusätzliche Element enthalten. Auf diese Weise kann eine besonders gute Gitteranpassung aller Schichten aller Laserstapel an die Gitterkonstante von GaAs erzielt werden.

Alternativ ist es aber auch möglich, dass nicht in jeder Wellenleiterschicht oder Mantelschicht mindestens eines Laserstapels AlₓGa₁₋ₓAs, mit 0 ≤ x ≤1, und/oder das mindestens eine zusätzliche Element enthalten ist, sondern der Laserdiodenchip Wellenleiterschichten oder Mantelschichten aufweist, die nicht AlₓGa₁₋ₓAs, mit 0 ≤ x ≤ 1, und/oder kein zusätzliches Element enthalten.

Eine weitere Ausgestaltung der Erfindung sieht vor, dass das mindestens eine zusätzliche Element innerhalb der mindestens einen Wellenleiterschicht oder Mantelschicht in seiner Konzentration räumlich variiert. Beispielsweise nimmt die Konzentration des zusätzlichen Elements in einer der Schichten eines Laserstapels in Richtung der aktiven Zone ab.

Dadurch kann vorzugsweise die Gitteranpassung der Schicht mit dem zusätzlichen Element an die zwei angrenzenden Schichten, die sich oberhalb und unterhalb der Schicht mit dem zusätzlichen Element befinden, verbessert werden.

Vorzugsweise weist die mindestens eine Wellenleiterschicht oder Mantelschicht, die AlₓGa₁₋ₓAs, mit 0 ≤ x ≤ 1, und das zusätzliche Element enthält, mindestens ein weiteres zusätzliches Element der III. oder V. Hauptgruppe auf. Das bedeutet, dass die mindestens eine Wellenleiterschicht oder Mantelschicht, die das zusätzliche Element und das weitere zusätzliche Element aufweist, sich aus fünf oder mehr Komponenten zusammensetzt.

Beispielsweise enthält eine der Wellenleiterschichten oder Mantelschichten des ersten Laserstapels Phosphor als zusätzliches Element und Indium als weiteres zusätzliches Element.

Bevorzugt enthält die mindestens eine Wellenleiterschicht oder Mantelschicht InAlGaAsP, InAlGaAsPSb oder AlGaAsPSb.

Eine weitere Ausgestaltung der Erfindung sieht vor, dass mindestens eine weitere Wellenleiterschicht oder Mantelschicht AlₓGa₁₋ₓAs, mit 0 ≤ x ≤ 1, und mindestens ein weiteres Element der III. oder V. Hauptgruppe aufweist, so dass sich die Gitterfehlanpassung zwischen der mindestens einen weiteren Wellenleiterschicht oder Mantelschicht mit dem mindestens einen weiteren Element und dem Halbleitersubstrat aus GaAs verringert.

Beispielsweise enthält die erste Mantelschicht des ersten Laserstapels AlₓGa₁₋ₓAs, mit 0 ≤ x ≤ 1, und als zusätzliches Element Phosphor und zusätzlich enthält eine weitere Schicht, beispielsweise die erste Wellenleiterschicht des zweiten Laserstapels, AlₓGa₁₋ₓAs, mit 0 ≤ x ≤ 1, und ein weiteres Element der III. oder V. Hauptgruppe, beispielsweise Stickstoff.

Dadurch können vorzugsweise die Gitteranpassungen beider Schichten, also beispielsweise der ersten Mantelschicht des ersten Laserstapels und zusätzlich der ersten Wellenleiterschicht des zweiten Laserstapels, durch das zusätzliche Element und durch das von dem zusätzlichen Element verschiedene weitere Element an die Gitterkonstante des Halbleitersubstrats aus GaAs optimiert werden.

Vorzugsweise ist die Gitteranpassung jeder einzelnen Schicht des Laserdiodenchips an die jeweils zwei angrenzenden Schichten homogen. Dadurch ergeben sich zwischen allen Schichten des Laserdiodenchips gleich große Gitterfehlanpassungen und somit kann sich in dem Laserdiodenchip insgesamt eine verringerte konstante Verspannung ergeben.

Bei einer weiteren Ausgestaltung weisen die mindestens eine Wellenleiterschicht oder Mantelschicht mit dem mindestens einen zusätzlichen Element und mindestens eine angrenzende Schicht die gleiche Gitterkonstante auf. Dabei ist es nicht zwingend notwendig, dass jede Schicht des Laserdiodenchips die gleiche Gitterkonstante aufweist, vielmehr können geringe lokale Gitterfehlanpassungen zwischen einzelnen Schichten des Laserdiodenchips bestehen bleiben, solange sich insgesamt die Gitterfehlanpassungen des Laserdiodenchips reduzieren.

Bevorzugt ist das mindestens eine zusätzliche Element ein Element der V. Hauptgruppe, wobei der Anteil des zusätzlichen Elements an den Elementen der V. Hauptgruppe in der mindestens einen Wellenleiterschicht oder Mantelschicht höchstens 15% beträgt. Beispielsweise enthält die Wellenleiterschicht oder Mantelschicht AlₓGa₁₋ₓAs_{y}P_{1-y}, wobei 0 ≤ x ≤ 1 und 1-y ≤ 0,15 ist.

Alternativ ist das mindestens eine zusätzliche Element ein Element der III. Hauptgruppe, wobei der Anteil des zusätzlichen Elements an den Elementen der III. Hauptgruppe in der mindestens einen Wellenleiterschicht oder Mantelschicht höchstens 15% beträgt. Beispielsweise enthält die Wellenleiterschicht oder Mantelschicht In_{1-x-z}AlₓGa_{z}AS_{y}P_{1-y}, wobei 0 ≤ x, y, z < 1, x+z < 1, und 1-x-z ≤ 0,15 ist.

### Für eine Anpassung der Gitterkonstante einer

Wellenleiterschicht oder Mantelschicht an die Gitterkonstante des Halbleitersubstrats, also an die Gitterkonstante von GaAs, enthält beispielsweise die Wellenleiterschicht oder Mantelschicht AlₓGa₁₋ₓAS_{y}P_{1-y}, wobei 0 ≤ x ≤ 1 und 0,02 ≤ 1-y ≤ 0,03 ist. Es ist des Weiteren auch möglich, dass die Wellenleiterschicht oder Mantelschicht einen höheren Anteil an dem zusätzlichen Element, beispielsweise Phosphor, aufweist. Beispielsweise enthält die Wellenleiterschicht oder Mantelschicht AlₓGa₁₋ₓAs_{y}P_{1-y}, wobei 0 ≤ x ≤ 1 und 1-y = 0,08 ist, wodurch sich eine tensile Verspannung ergeben würde. Weist diese Wellenleiterschicht oder Mantelschicht zusätzlich ein weiteres Element auf, beispielsweise In, welches tendenziell zu einer kompressiven Verspannung führen würde, kann bei geeigneter Zusammensetzung dieser Wellenleiterschicht oder Mantelschicht ebenfalls eine Gitteranpassung an die Gitterkonstante von GaAs erreicht werden.

Darüber hinaus sind weitere Konstellationen denkbar, bei denen weitere Zusammensetzungen aus Elementen der III. und/oder V. Hauptgruppe in geeigneter Weise an GaAs gitterangepasst gewachsen werden. Dabei sind auch Zusammensetzungen einer Schicht aus mehr als fünf Komponenten vorstellbar.

Vorzugsweise enthält die Wellenleiterschicht oder Mantelschicht AlₓGa₁₋ₓAs_{y}P_{1-y}, wobei 0 ≤ x ≤ 1 und 1-y ≤ 0,15 ist oder AlₓGa₁₋ₓAs_{y}N_{1-y}, wobei 0 ≤ x ≤ 1 und 1-y ≤ 0,10 ist.

Als weiteres Element, das die Gitterkonstante einer AlₓGa₁₋ₓAS_{y}P_{1-y}, mit 0 ≤ x, y < 1, enthaltenden Wellenleiterschicht oder Mantelschicht vergrößert und somit eine vorhandene tensile Verspannung verringern kann, die durch den zugeführten Phosphor entstehen kann, ist in dieser Wellenleiterschicht oder Mantelschicht bevorzugt In oder Sb enthalten. Vorzugsweise enthält die Wellenleiterschicht oder Mantelschicht In_{1-x-z}AlₓGa_{z}As_{y}P_{1-y}, wobei 0 ≤ x, y, z < 1 und 1-x-z ≤ 0,15 ist oder AlₓGa_{z}Sb_{1-x-z}As_{y}P_{1-y}, wobei 0 ≤ x, y, z < 1 und 1-x-z ≤ 0,10 ist.

Der Laserdiodenchip kann beispielsweise zwei oder drei Laserstapel aufweisen. Insbesondere ist es aber auch möglich, dass der Laserdiodenchip vier oder mehr, besonders bevorzugt sogar fünf oder mehr Laserstapel aufweist. Die Anordnung einer Vielzahl von monolithisch integrierten Laserstapeln in dem Laserdiodenchip wird durch mindestens ein zusätzliches Element der III. oder V. Hauptgruppe zu AlₓGa₁₋ₓAs, mit 0 ≤ x ≤ 1 in mindestens einer Wellenleiterschicht oder Mantelschicht mindestens eines Laserstapels erleichtert, da durch das zusätzliche Element annähernd keine Gitterfehlanpassungen zwischen dem Halbleitersubstrat aus GaAs und der mindestens einen Wellenleiterschicht oder Mantelschicht, und somit auch annähernd keine Verspannungen zwischen diesen Schichten auftreten, die bei einer Vielzahl von monolithisch integrierten Laserstapeln zur Zerstörung des Laserdiodenchips führen könnten.

In einer weiteren vorteilhaften Ausgestaltung ist zwischen mindestens zwei Laserstapeln ein Tunnelübergang angeordnet. Der Tunnelübergang ist bevorzugt in der Halbleiterschichtenfolge integriert und umfasst besonders bevorzugt zwei, vorzugsweise hochdotierte, Schichten unterschiedlichen Leitungstyps. Besonders bevorzugt ist zwischen allen Laserstapeln jeweils ein Tunnelübergang angeordnet.

Die jeweilige aktive Zone der Laserstapel umfasst bevorzugt einen pn-Übergang, eine Doppelheterostruktur, eine Mehrfach-Quantentopfstruktur (MQW) oder besonders bevorzugt eine Einfach-Quantentopfstruktur (SQW) zur Strahlungserzeugung. Die Bezeichnung Quantentopfstruktur beinhaltet hierbei keine Angabe über die Dimensionalität der Quantisierung. Sie umfasst somit u.a. Quantentröge, Quantendrähte und Quantenpunkte und jede Kombination dieser Strukturen.

In einer weiteren Ausgestaltung kann zur besseren Wärmeabfuhr der Laserdiodenchip auf einem Kühlkörper montiert werden. Dadurch erhöht sich zusätzlich die Lebensdauer der Laserdiodenchips.

Vorzugsweise ist zur Kontaktierung des Laserdiodenchips auf der den Laserstapeln abgewandte Oberfläche des Halbleitersubstrats eine Kontaktschicht aufgebracht. Zur weiteren Kontaktierung des Laserdiodenchips ist vorzugsweise auf dem von dem Substrat abgewandten Laserstapel eine Metallisierung aufgebracht. Diese Metallisierung kann ganzflächig ausgebildet sein, oder eine Strukturierung aufweisen.

Bevorzugt wird der Laserdiodenchip im quasi-kontinuierlichen (q-cw) Betriebsmodus mit Pulslängen vorzugsweise zwischen 50 µs und 1500 µs, besonders bevorzugt zwischen 100 µs und 1000 µs und einem Tastverhältnis (duty cycle) zwischen 1% und 20% betrieben. Simulationen zeigen, dass der erfindungsgemäße Laserdiodenchip in diesem Modus über längere Zeit und bei hohen Leistungen betreibbar ist.

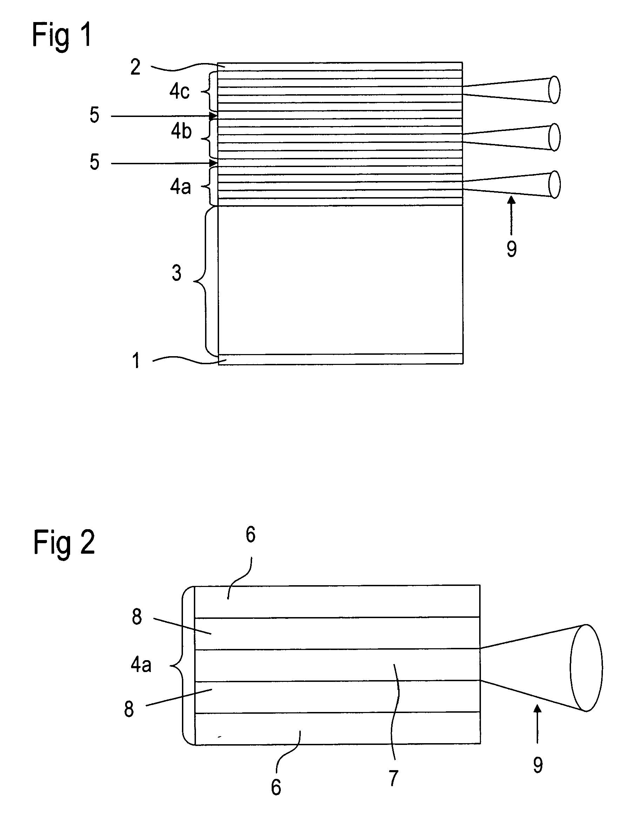

Weitere Merkmale, Vorteile, bevorzugte Ausgestaltungen und Zweckmäßigkeiten des Laserdiödenchips ergeben sich aus dem im Folgenden in Verbindung mit den Figuren 1 und 2 erläuterten Ausführungsbeispiel. Es zeigen:
Figur 1 einen schematischen Querschnitt eines ersten Ausführungsbeispiels eines erfindungsgemäßen Laserdiodenchips, und
Figur 2 eine schematische vergrößerte Darstellung eines Laserstapels des ersten Ausführungsbeispiels eines erfindungsgemäßen Laserdiodenchips.

Gleiche oder gleichwirkende Bestandteile sind jeweils mit den gleichen Bezugszeichen versehen. Die dargestellten Bestandteile sowie die Größenverhältnisse der Bestandteile untereinander sind nicht als maßstabsgerecht anzusehen.

Bei dem in Figur 1 dargestellten strahlungsemittierenden Laserdiodenchip weist der Laserdiodenchip einen Rückseitenkontakt 1, einen Vorderseitenkontakt 2, ein Halbleitersubstrat 3 aus GaAs und drei sich jeweils aus einer Anzahl von unterschiedlichen Schichten zusammensetzende Laserstapel 4a, 4b, 4c auf, die jeweils im Betrieb des Bauelements mindestens eine Strahlung (z.B. infrarote Strahlung) aussendende aktive Zone aufweisen.

Die drei monolithisch integrierten Laserstapel 4a, 4b, 4c des Laserdiodenchips sind auf einem Halbleitersubstrat 3 aus GaAs angeordnet. Die einzelnen Laserstapel sind durch Tunnelübergänge 5 miteinander verbunden.

Wie aus Figur 2 ersichtlich grenzen die Wellenleiterschichten 8 jedes monolithisch integrierten Laserstapels 4a, 4b, 4c, die jeweils die aktive Zone 7 umgeben, jeweils an Mantelschichten 6 an. Beispielsweise enthält der unterste Laserstapel 4a eine erste Mantelschicht 6, eine auf der ersten Mantelschicht 6 aufgebrachte erste Wellenleiterschicht 8, eine auf der ersten Wellenleiterschicht 8 aufgebrachte aktive Zone 7, eine auf der aktiven Zone 7 aufgebrachte zweite Wellenleiterschicht 8 und eine auf der zweiten Wellenleiterschicht 8 aufgebrachte zweite Mantelschicht 6.

Wie aus Figur 1 ersichtlich, schließt sich an der zweiten Mantelschicht 6 des ersten Laserstapels ein Tunnelübergang 5 an, auf dem die entsprechenden Schichten des zweiten Laserstapels 4b angeordnet sind. Auf den Laserstapel 4b folgt der Laserstapel 4c, wobei zwischen dem Laserstapel 4b und dem Laserstapel 4c ein weiterer Tunnelübergang 5 angeordnet ist.

Die jeweiligen aktiven Zonen 7 enthalten bevorzugt InGaAs oder AlInGaAs. Alternativ können die jeweiligen aktiven Zonen 7 allerdings auch andere Materialien enthalten.

Die jeweiligen aktiven Zonen 7 emittieren bei Beaufschlagung mit einem Strom beispielsweise elektromagnetische Strahlung aus dem infraroten Wellenlängenbereich. Sie können z.B. einen pn-Übergang, eine Doppelheterostruktur, eine Einfach-Quantentopfstruktur (SQW-Struktur) oder eine Mehrfach-Quantentopfstruktur (MQW-Struktur) aufweisen. Solche Strukturen sind dem Fachmann bekannt und werden von daher an dieser Stelle nicht näher erläutert. Die aktiven Zonen emittieren jeweils Licht im Abstrahlwinkel eines Lichtkegels 9.

Bei dem Laserdiodenchip sind vorzugsweise sowohl die Wellenleiterschichten 8, als auch die Mantelschichten 6 der drei Laserstapel jeweils durch AlₓGa₁₋ₓAs, mit 0 ≤ x ≤ 1, und ein zusätzliches Element, beispielsweise Phosphor, optimiert. Diese Schichten enthalten vorzugsweise AlₓGa_{1-X}AS_{Y}P_{1-Y}, wobei 0 ≤ x < 1 und 0 ≤ y < 1. Es ist allerdings auch denkbar, das diese Schichten weitere zusätzliche Elemente, wie beispielsweise In, Sb oder N enthalten, so dass sich Zusammensetzungen aus InAlGaAsP, InAIGaAsPSb oder AlGaAsPSb ergeben.

Durch das zusätzliche Element oder die zusätzlichen Elemente nähert sich die Gitterkonstante der Wellenleiterschichten 8 und Mantelschichten 6 an die Gitterkonstante des Halbleitersubstrats 3, das aus GaAs besteht, an, so dass annähernd keine lokalen Verspannungen zwischen benachbarten Schichten auftreten. Besonders bevorzugt treten keine Gitterfehlanpassungen, und somit keine Verspannungen zwischen benachbarten Schichten auf. Es besteht auch die Möglichkeit, nur einzelne Wellenleiterschichten 8 oder Mantelschichten 6 der Laserstapel durch ein oder mehrere zusätzlichen Elemente zu optimieren.

Die Herstellung der oben beschriebenen Schichtenfolgen kann beispielsweise mittels Molekularstrahlepitaxie erfolgen. Die Herstellung ist auch mit metallorganischer Gasphasenepitaxie, Gasphasenepitaxie oder Flüssigphasenepitaxie möglich.

Die Beschreibung des Ausführungsbeispiels ist nicht als Einschränkung auf die Anzahl der einzelnen Schichten zu verstehen. Einzelne Wellenleiterschichten oder Mantelschichten können sich ebenso aus einer Schichtenfolge zusammensetzten. Ebenso kann der Laserdiodenchip zusätzlich zu den oben genannten Schichten beispielsweise Bufferschichten, Barriereschichten, Zwischenschichten und/oder Übergangsschichten enthalten. Ferner können die einzelnen Schichten des Laserdiodenchips unterschiedliche Dotierungen aufweisen.

Die Erläuterung des erfindungsgemäßen Laserdiodenchips anhand des oben beschriebenen Ausführungsbeispiels ist nicht als Beschränkung der Erfindung auf diese zu betrachten. Vielmehr umfasst die Erfindung jedes neue Merkmal sowie jede Kombination von Merkmalen, was insbesondere jede Kombination von Merkmalen in den Patentansprüchen beinhaltet, auch wenn dieses Merkmal oder diese Kombination selbst nicht explizit in den Patentansprüchen oder dem Ausführungsbeispiel angegeben ist.

## Patentansprüche

1. Monolithisch integrierter Laserdiodenchip mit einem Aufbau als Mehrfachstrahl-Laserdiode, der auf einem Halbleitersubstrat (3) aus GaAs mindestens zwei übereinander angeordnete Laserstapel (4a, 4b, 4c) aufweist, die jeweils eine aktive Zone (7) enthalten, die zwischen Wellenleiterschichten (8) angeordnet ist, und die Wellenleiterschichten (8) an einer von der aktiven Zone (7) abgewandten Seite jeweils an eine Mantelschicht (6) angrenzen, wobei mindestens eine der Wellenleiterschichten (8) oder Mantelschichten (6) mindestens eines Laserstapels (4a, 4b, 4c) AlₓGa₁₋ₓAs, mit 0 ≤ x ≤ 1, und mindestens ein zusätzliches Element der III. oder V. Hauptgruppe aufweist, so dass sich die Gitterfehlanpassung zwischen der mindestens einen Wellenleiterschicht (8) oder Mantelschicht (6) mit dem mindestens einen zusätzlichen Element und dem Halbleitersubstrat (3) aus GaAs verringert.

2. Laserdiodenchip nach Anspruch 1, wobei
das mindestens eine zusätzliche Element P, N, In oder Sb ist.

3. Laserdiodenchip nach einem der vorhergehenden Ansprüche, wobei
sich durch das mindestens eine zusätzliche Element die Gitterkonstante der mindestens einen Wellenleiterschicht (8) oder Mantelschicht (6) verringert.

4. Laserdiodenchip nach einem der vorhergehenden Ansprüche, wobei
mindestens eine Wellenleiterschicht (8) und mindestens eine Mantelschicht (6) oder mindestens zwei Wellenleiterschichten (8) oder mindestens zwei Mantelschichten (6) AlₓGa₁₋ₓAs, mit 0 ≤ x ≤ 1, und das mindestens eine zusätzliche Element aufweisen.

5. Laserdiodenchip nach Anspruch 4, wobei
mindestens eine Wellenleiterschicht (8) und mindestens eine Mantelschicht (6) oder mindestens zwei Wellenleiterschichten (8) oder mindestens zwei Mantelschichten (6) das mindestens eine zusätzliche Element in unterschiedlicher Konzentration aufweisen.

6. Laserdiodenchip nach einem der vorhergehenden Ansprüche, wobei
in jeder Wellenleiterschicht (8) und jeder Mantelschicht (6) mindestens eines Laserstapels (4a, 4b, 4c) AlₓGa₁₋ₓAs, mit 0 ≤ x ≤ 1, und das mindestens eine zusätzliche Element enthalten ist.

7. Laserdiodenchip nach einem der vorhergehenden Ansprüche, wobei
in jeder Wellenleiterschicht (8) und jeder Mantelschicht (6) jedes Laserstapels (4a, 4b, 4c) AlₓGa₁₋ₓAs, mit 0 ≤ x ≤ 1, und das mindestens eine zusätzliche Element enthalten ist.

8. Laserdiodenchip nach einem der vorhergehenden Ansprüche, wobei
das mindestens eine zusätzliche Element innerhalb der mindestens einen Wellenleiterschicht'(8) oder Mantelschicht (6) in seiner Konzentration räumlich variiert.

9. Laserdiodenchip nach einem der vorhergehenden Ansprüche, wobei
die mindestens eine Wellenleiterschicht (8) oder Mantelschicht (6) mindestens ein weiteres zusätzliches Element der III. oder V. Hauptgruppe aufweist.

10. Laserdiodenchip nach Anspruch 9, wobei
die mindestens eine Wellenleiterschicht (8) oder Mantelschicht (6) InAlGaAsP, InAlGaAsPSb oder AlGaAsPSb enthält.

11. Laserdiodenchip nach einem der vorhergehenden Ansprüche, wobei
mindestens eine weitere Wellenleiterschicht (8) oder Mantelschicht (6) AlₓGa₁₋ₓAs, mit 0 ≤ x ≤ 1, und mindestens ein weiteres Element der III. oder V. Hauptgruppe aufweist, so dass sich die Gitterfehlanpassung zwischen der mindestens einen weiteren Wellenleiterschicht (8) oder Mantelschicht (6) mit dem mindestens einen weiteren Element und dem Halbleitersubstrat (3) aus GaAs verringert.

12. Laserdiodenchip nach einem der vorhergehenden Ansprüche, wobei
die mindestens eine Wellenleiterschicht (8) oder Mantelschicht (6) mit dem mindestens einen zusätzlichen Element und das Halbleitersubstrat (3) aus GaAs die gleiche Gitterkonstante aufweisen.

13. Laserdiodenchip nach einem der vorhergehenden Ansprüche, wobei
das mindestens eine zusätzliche Element ein Element der V. Hauptgruppe ist, wobei der Anteil des zusätzlichen Elements an den Elementen der V. Hauptgruppe in der mindestens einen Wellenleiterschicht (8) oder Mantelschicht (6) höchstens 15% beträgt.

14. Laserdiodenchip nach einem der vorhergehenden Ansprüche 1 bis 12, wobei
das mindestens eine zusätzliche Element ein Element der III. Hauptgruppe ist, wobei der Anteil des zusätzlichen Elements an den Elementen der III. Hauptgruppe in der mindestens einen Wellenleiterschicht (8) oder Mantelschicht (6) höchstens 15% beträgt.

15. Laserdiodenchip nach einem der vorhergehenden Ansprüche, wobei
die Laserstapel (4a, 4b, 4c) durch Tunnelübergänge (5) miteinander verbunden sind.
